# EUROPÄISCHE PATENTSCHRIFT

(11) **EP 3 577 686 B1**
(45) Veröffentlichungstag und Bekanntmachung des Hinweises auf die Patenterteilung: **14.04.2021**
(21) Anmeldenummer: 18710304.9
(22) Anmeldetag: 05.02.2018
(51) Int. Cl.: H01L 23/544, H01L 23/00

(54) **VERFAHREN ZUM FESTLEGEN EINES BONDGUTS IN EINEM ARBEITSBEREICH EINES BONDERS**
METHOD FOR FIXING A WORKPIECE TO BE BONDED IN A WORKING AREA OF A BONDER
PROCÉDÉ DE FIXATION D'UN PIÈCE À SOUDER DANS UNE ZONE DE TRAVAIL D'UN DISPOSITIF DE SOUDAGE

(30) Priorität: 03.02.2017 DE 102017102182; 06.02.2017 DE 102017102259
(43) Veröffentlichungstag der Anmeldung: 11.12.2019
(73) Patentinhaber: Hesse GmbH, 33104 Paderborn (DE)
(72) Erfinder: HESSE, Hans-Jürgen, 33106 Paderborn (DE); BELTING, Gregor, 33106 Paderborn (DE); RIESE, Markus, 33121 Kassel (DE)
(74) Vertreter: Wickord, Wiro
(86) Internationale Anmeldenummer: PCT/DE2018/100090
(87) Internationale Veröffentlichungsnummer: WO 2018/141339

(56) Entgegenhaltungen:
- WO-A2-2012/092058
- US-A1- 2004 261 977

## Beschreibung

Die Erfindung betrifft ein Verfahren zum Festlegen eines Bondguts in einem Arbeitsbereich eines Bonders mittels einer Klemmvorrichtung. Die Klemmvorrichtung sieht eine Mehrzahl von Klemmfingern vor, welche korrekt positioniert werden müssen, um den Bondvorgang ordnungsgemäß durchführen zu können.

Aus der US 9 393 641 B1 (Basis für den Oberbegriff des Anspruchs 1) ist bekannt, mittels einer Kamera ein Live-Bild der Klemmeinrichtung oder eines Teilbereichs derselben zu erfassen und auf einem Bildschirm darzustellen. Auf dem Bildschirm wird dann zusätzlich zu dem Live-Bild der Kamera über Grafikelemente eine Sollposition für die Klemmeinrichtung eingeblendet. Die Grafikelemente sind dabei in Form einer Überblendung unmittelbar auf das Live-Bild der Kamera gelegt. Der Maschinenführer kann insofern bei der Einrichtung der Maschinen und insbesondere bei der Positionierung der Klemmeinrichtung deren Position so lange korrigieren, bis die Klemmeinrichtung in der Sollposition vorgesehen ist.

Aufgabe der vorliegenden Erfindung ist es, ein verbessertes Verfahren zur Positionierung der Klemmeinrichtung für das Bondgut anzugeben, bei dem der Maschinenführer zusätzlich unterstützt und der Einrichtungsprozess weiter vereinfacht wird.

Zur Lösung der Aufgabe weist die Erfindung die Merkmale des Patentanspruchs 1 auf. Insbesondere ist es so, dass das erfindungsgemäße Verfahren eine Initialisierungsroutine und eine nach dem Durchführen der Initialisierungsroutine wiederholt durchzuführende Übernahmeroutine umfasst. Während der Initialisierungsroutine wird die Klemmeinrichtung bevorzugt von einem sehr erfahrenen Maschinenführer oder einem anderen technisch geschulten Fachmann erstmalig für ein spezifisches Bondgut eingerichtet. Es werden insofern das Bondgut und die Klemmeinrichtung im Arbeitsbereich des Bonders platziert. An dem Bondgut vorgesehene Bondgut-Referenzmarken werden mittels einer Kamera des Bonders erfasst und gespeichert. Anhand der Lage der Bondgut-Referenzmarken werden die Position und/oder die Orientierung des Bondguts relativ zum Bonder bestimmt. Des Weiteren werden Klemmfinger der Klemmeinrichtung so in eine Klemmposition verbracht und an den Klemmfingern der Klemmeinrichtung vorgesehene Klemmflächen derart gegen das Bondgut angelegt, dass in einem nachfolgenden Arbeitsschritt an vorbestimmten Anschlussflächen des Bondguts ein Anschlusskontakt hergestellt werden kann, ohne dass das Bondgut in unzulässiger Weise zu Schwingungen angeregt wird und/oder es beim Verfahren beziehungsweise Positionieren eines Bondwerkzeugs des Bonders zu einer Kollision mit der Klemmeinrichtung kommt. Die Klemmposition der Klemmfinger wird dann mittels der Kamera erfasst und es wird die Klemmposition relativ zur Position und/oder Orientierung des Bondguts als Klemmfinger-Sollposition berechnet und gespeichert.

Nach der erstmaligen Einrichtung der Klemmeinrichtung ist die Klemmfinger-Sollposition bekannt. Es kann insofern im Rahmen der Übernahmeroutine bei einer wiederholten Verarbeitung des gleichen Bondguts die bekannte Klemmfinger-Sollposition übernommen und die Positionierung der Klemmeinrichtung rechnerunterstützt sehr einfach durchgeführt werden. Beispielsweise kann ein Maschinenführer das Bondgut und die Klemmeinrichtung mit den Klemmfingern im Arbeitsbereich des Bonders positionieren und die aktuelle Position und Orientierung des Bondguts und der Klemmeinrichtung mittels der Kamera erfassen. Anhand der aktuellen Position und Orientierung des Bondguts und der Klemmeinrichtung und anhand der gespeicherten Klemmfinger-Sollposition wird eine initiale Fehlstellung der Klemmfinger berechnet und angezeigt. Iterativ wird dann die aktuelle Position und/oder Orientierung der Klemmfinger solange korrigiert und mittels der Kamera neu erfasst und eine neue Fehlstellung der Klemmfinger berechnet und angezeigt, bis die Position und Orientierung der Klemmfinger der Klemmfinger-Sollposition entspricht. Es ist hierbei ausreichend, wenn die Klemmfinger in einem zulässigen Toleranzbereich vorgesehen sind. Maßgeblich ist insofern, dass die nachfolgenden Arbeitsschritte zuverlässig durchgeführt werden können und es insbesondere zu keiner unzulässigen Schwingungsanregung des Bondguts kommt und dass das an einem Bondkopf des Bonders gehaltene Bondwerkzeug kollisionsfrei verfahren und positioniert werden kann.

Der besondere Vorteil der Erfindung besteht darin, dass zunächst einmalig eine besonders vorteilhafte Sollposition für die Klemmeinrichtung bestimmt wird. Die Sollposition wird gespeichert und nachfolgend verwendet, um die Klemmeinrichtung später für dasselbe Bondgut erneut zu positionieren. Dabei wird mittels des erfindungsgemäßen Verfahrens der Maschinenführer insbesondere dadurch unterstützt, dass die Fehlstellung berechnet und angezeigt wird. Der Maschinenführer ist insofern präzise über die aktuelle Position beziehungsweise Orientierung der Klemmeinrichtung informiert. Darüber hinaus wird ihm die Fehlstellung angezeigt, sodass er das Maß der notwendigen Korrektur sehr schnell erfassen und die Positionierung in kurzer Zeit zuverlässig und fehlerfrei durchführen kann.

Im Rahmen der Erfindung ist vorgesehen, dass zur Einrichtung und Positionierung der Klemmeinrichtung insbesondere das gleiche Kamerasystem eingesetzt wird, welches konventionelle Bonder beispielsweise zum Erfassen der Lage und/oder der Orientierung eines Chips aufweisen. Über Bildverarbeitungsroutinen können diese Kamerasysteme die Lage der Anschlussflächen an dem Chip sehr exakt bestimmen. Mittels derartiger Bildauswerteroutinen wird im Rahmen des vorliegenden erfindungsgemäßen Verfahrens die Lage und/oder Orientierung des Bondguts beziehungsweise der Klemmfinger erfasst.

Die Klemmeinrichtung kann beispielsweise die Mehrzahl an Klemmfingern und eine Klemmplatte vorsehen, welche dazu dient, die Klemmeinrichtung auf eine Arbeitsfläche des Bonders aufzulegen und die Klemmfinger zu tragen. Die Klemmeinrichtung kann einteilig ausgebildet sein beziehungsweise eine lagefeste Zuordnung der Klemmfinger zur Klemmplatte vorsehen. Beispielsweise kann die Klemmeinrichtung mehrteilig ausgebildet sein mit der Möglichkeit, jeden einzelnen Klemmfinger individuell relativ zu den anderen und zu der Klemmplatte zu verschieben oder eine Gruppe von Klemmfingern relativ zur Klemmplatte und den anderen Klemmfinger einzustellen.

Bei der Durchführung des erfindungsgemäßen Verfahrens kann beispielsweise zunächst nur das Bondgut in dem Arbeitsbereich des Bonders platziert werden. Bevor die Klemmeinrichtung ebenfalls im Arbeitsbereich des Bonders platziert wird, werden zunächst die Bondgut-Referenzmarken bestimmt. Nachdem die Bondgut-Referenzmarken bestimmt sind und die Klemmeinrichtung im Arbeitsbereich positioniert wird, werden dann die Klemmeinrichtung insgesamt oder die einzelnen Klemmfinger so ausgerichtet und gegen das Bondgut angelegt, dass der Bondprozess anschließend korrekt durchgeführt werden kann. Vorteilhaft ist die Erfassung der Bondgut-Referenzmarken einfach, wenn die Klemmeinrichtung noch nicht im Arbeitsbereich positioniert ist, da eine Überdeckung vermieden werden kann. Alternativ kann vorgesehen sein, das Bondgut und die Klemmeinrichtung zunächst im Arbeitsbereich zu positionieren und dann die Referenzmarken zu erfassen.

Nach einer bevorzugten Ausführungsform der Erfindung wird die aktuelle Position und/oder Orientierung der Klemmfinger und/oder die Klemmfinger-Sollposition mittels der Kamera bestimmt, indem eine an den Klemmfingern vorgesehene Positioniermarke (Klemmfinger-Positioniermarke) und/oder -jedenfalls abschnittsweise - eine Kontur der Klemmfinger erfasst und als Klemmfinger-Referenzmarke abgespeichert wird. Vorteilhaft kann durch das Erfassen der Klemmfinger-Positioniermarke und/oder der jedenfalls teilweisen Konturerfassung die Position und Orientierung der Klemmfinger schnell und zuverlässig ermittelt werden.

Nach einer Weiterbildung der Erfindung wird die Kamera zur Bestimmung der Bondgut-Referenzmarken und/oder der Klemmfinger-Sollposition und/oder der Klemmfinger-Referenzmarken über den Bondgut-Referenzmarken und/oder den Klemmfinger-Referenzmarken positioniert und/oder manuell verfahren. Indem die Kamera über den Referenzmarken positioniert wird, werden die Genauigkeit des Verfahrens und insbesondere die Genauigkeit der Bildverarbeitung weiter verbessert. Darüber hinaus ist das erfindungsgemäße Verfahren besonders intuitiv bedienbar, wenn die Kamera manuell verfahren wird. Alternativ kann die Kamera automatisch verfahren werden.

Beispielsweise kann die Kamera im Rahmen der Initialisierungsroutine manuell und im Rahmen der Übernahmeroutine automatisiert verfahren werden.

Nach einer Weiterbildung der Erfindung wird in der Initialisierungsphase mittels der Kamera ein Referenzbild aufgenommen und gespeichert, nachdem die Klemmfinger in der Klemmfinger-Sollposition vorgesehen sind. Vorteilhaft kann durch das Bereitstellen des Referenzbilds der Maschinenführer insbesondere während der Übernahmeroutine weiter entlastet werden, da er optisch die Sollposition erfassen und insofern die Klemmfinger jedenfalls näherungsweise in die vorgesehene Position verbringen kann.

Nach einer Weiterbildung der Erfindung kann die Positionierung der Klemmfinger insbesondere in der Übernahmeroutine weiter vereinfacht werden, wenn an dem Bondgut Klemmmarken an den Stellen vorgesehen sind, an denen die Klemmflächen der Klemmfinger zu positionieren sind. Die Klemmmarken können beispielsweise ebenso wie die Bondgut-Positioniermarken und/oder die Klemmfinger-Positioniermarken während des Fertigungsprozesses des Bondguts oder bei der Herstellung der Klemmeinrichtung an dem Bondgut beziehungsweise den Klemmfingern vorgesehen sein. Sofern eine einteilige Klemmeinrichtung vorgesehen wird, bei der die Klemmfinger nicht relativ zur Klemmplatte verstellt werden können, können die Klemmfinger-Positioniermarken auch an der Klemmplatte vorgesehen sein.

Nach einer Weiterbildung der Erfindung können in der Übernahmeroutine ein Live-Bild der Kamera oder das Referenzbild und/oder eine Referenzdarstellung der Klemmfinger-Sollposition einerseits und örtlich getrennt hiervon die Fehlstellung der Klemmfinger andererseits angezeigt werden. Auf das Einblenden von Positioniermarken, Konturen oder anderen Justagehilfsmitteln in das Life-Bild wird insofern im Rahmen der Erfindung verzichtet. Als Referenzdarstellung dient beispielsweise ein Auszug einer CAD-Zeichnung oder ein anderes geeignetes grafisches Modell der Klemmeinrichtung beziehungsweise des Klemmfingers.

Nach einer Weiterbildung der Erfindung werden bei einer Klemmeinrichtung, welche wenigstens einzelne relativ zur Klemmplatte einstellbare Klemmfinger aufweist, die einstellbaren Klemmfinger nacheinander positioniert beziehungsweise justiert. Die Auswahl der Reihenfolge, in der die Klemmfinger justiert werden, kann beispielsweise manuell vom Maschinenführer vorgenommen werden.

Nach einer Weiterbildung der Erfindung kann die Fehlstellung der Klemmfinger visualisiert werden, indem die aktuelle Position und/oder Orientierung der Klemmfinger einerseits und getrennt davon die Klemmfinger-Sollposition angezeigt wird und/oder indem eine Verstellrichtung angezeigt wird, in die die Klemmfinger verschoben beziehungsweise verschwenkt werden müssen, um sie in die Klemmfinger-Sollposition zu verbringen. Beispielsweise kann die Fehlstellung relativ zur Klemmfinger-Sollposition berechnet und angezeigt werden. Vorteilhaft vereinfacht sich die korrekte Positionierung der Klemmfinger durch die vorstehend beschriebenen Mittel zur Visualisierung der Fehlstellung weiter. Insbesondere können das Maß der Fehlstellung zahlenmäßig dargestellt beziehungsweise erfasst werden und durch die gekennzeichnete Verstellrichtung der Einrichtungsprozess signifikant beschleunigt werden.

Nach einer Weiterbildung der Erfindung wird die Fehlstellung visualisiert, indem die Klemmfinger-Sollposition und die aktuelle Position beziehungsweise Orientierung der Klemmfinger addiert und als Summenbild angezeigt werden. Vorteilhaft ergibt sich durch die Summenbilddarstellung für den Maschinenführer ein optisches Maß für die Fehlstellung. Sofern im Summenbild letztlich nur noch die Geometrie des Klemmfingers selbst angezeigt wird, ist der Klemmfinger in der Klemmfinger-Sollposition. In diesem Fall kann beispielsweise das Summenbild in einer anderen Farbe angezeigt werden. Sofern die Fehlstellung unzulässig groß ist, kann das Summenbild beispielsweise in rot angezeigt werden. Sobald der Klemmfinger ausreichend exakt positioniert ist, kann das Summenbild grün dargestellt werden. Der Maschinenführer wird hierdurch weiter entlastet.

Nach einer Weiterbildung der Erfindung kann zur Visualisierung der Fehlstellung ein Differenzbild angezeigt werden, welches sich durch Subtraktion der Klemmfinger-Sollposition von der aktuellen Position und/oder Orientierung der Klemmfinger ergibt. Analog zur Realisierung der Summenbilddarstellung kann auch das Differenzbild farbig variabel gestaltet sein etwa mit der Maßgabe, dass das Differenzbild grün angezeigt wird, wenn der Klemmfinger ausreichend exakt positioniert ist, und bei einer unzulässig großen Abweichung zur Klemmfinger-Sollposition das Differenzbild in rot angezeigt wird.

Nach einer Weiterbildung der Erfindung können im Rahmen der Initialisierungsroutine vor dem Speichern der Klemmfinger-Sollposition testweise einzelne oder alle Anschlusskontakte für das Bondgut hergestellt werden. Vorteilhaft kann hierdurch verifiziert werden, dass Schadschwingungen und Kollisionen vermieden sind.

Nach einer Weiterbildung der Erfindung wird das Bondgut mittels einer Fördereinrichtung in den Arbeitsbereich des Bonders positioniert. Durch das Vorsehen einer Fördereinrichtung, insbesondere einer in der Bond- beziehungsweise Halbleitertechnik üblichen Fördereinrichtung, kann das Bondgut wiederkehrend mit einer derartigen Genauigkeit im Arbeitsbereich des Bonders positioniert werden, dass die Klemmeinrichtung mit besonders wenig Aufwand positioniert und insbesondere während der Verarbeitung einer großen Stückzahl gleicher Bondgüter nicht nachjustiert werden muss.

Nach einer Weiterbildung der Erfindung wird im Rahmen der Übernahmeroutine eine zur Anlage der Kontaktfläche der Klemmeinrichtung vorgesehenen Montagestelle an dem Bondgut mittels eines Lasers markiert. Vorteilhaft vereinfacht sich durch das Markieren der Montagestelle die Justage der Klemmeinrichtung weiter.

Aus den weiteren Unteransprüchen und der nachfolgenden Beschreibung sind weitere Vorteile, Merkmale und Einzelheiten der Erfindung zu entnehmen. Dort erwähnte Merkmale können jeweils einzeln für sich oder auch in beliebiger Kombination erfindungswesentlich sein. Die Zeichnungen dienen lediglich beispielhaft der Klarstellung der Erfindung und haben keinen einschränkenden Charakter.

Es zeigen:
- Fig. 1: eine Aufsicht auf ein Bondgut in einer Teildarstellung,
- Fig. 2: eine Prinzipdarstellung einer Klemmeinrichtung mit einer Grundplatte und insgesamt zwölf relativ zur Grundplatte verstellbaren Klemmfingern,
- Fig. 3: eine Prinzipdarstellung einer Klemmsituation, in der das Bondgut nach Fig. 1 mittels der Klemmeinrichtung nach Fig. 2 fixiert ist,
- Fig. 4: die Darstellung nach Fig. 3 in einer Aufsicht, wobei auf die Darstellung nicht sichtbarer Konturen verzichtet ist,
- Fig. 5: ein erstes Beispiel einer Darstellung einer Fehlstellung von drei Klemmfingern der Klemmeinrichtung,
- Fig. 6: ein zweites Beispiel für die Darstellung der Fehlstellung der drei Klemmfinger und
- Fig. 7: ein drittes Beispiel für die Darstellung der Fehlstellung der drei Klemmfinger.

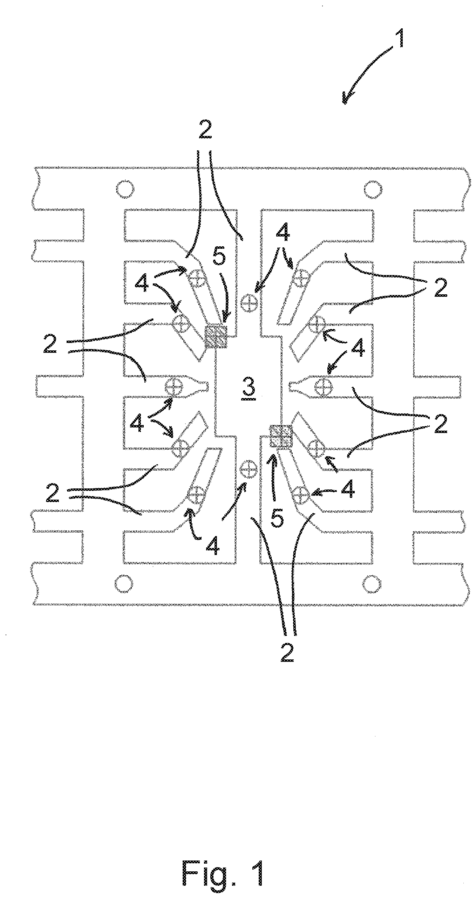

In Fig. 1 ist exemplarisch ein Bondgut 1 dargestellt mit insgesamt zwölf Stegen 2 sowie einer Anlagefläche 3 für einen nicht dargestellten Chip, der elektrisch leitend mit dem Bondgut 1 verbunden werden soll. Jedem Steg 2 sind darüber hinaus Klemm-Marken 4 zugeordnet. Schließlich sind zwei Bondgut-Referenzmarken 5 dargestellt, welche durch eine charakteristische Kontur des Bondguts 1 im Bereich der Anlagefläche 3 gebildet sind.

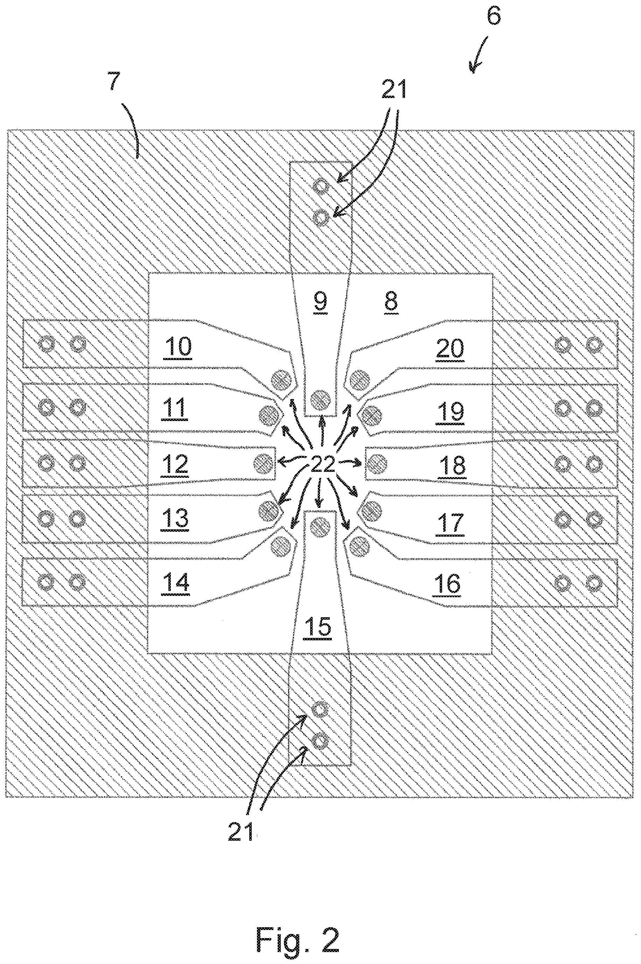

Fig. 2 zeigt eine Klemmeinrichtung 6 mit einer Klemmplatte 7, welche eine zentrale Aussparung 8 für das Bondgut 1 aufweist. Des Weiteren sind insgesamt zwölf Klemmfinger 9, 10, 11, 12, 13, 14, 15, 16, 17, 18, 19, 20 vorgesehen. Die Klemmfinger 9, 10, 11, 12, 13, 14, 15, 16, 17, 18, 19, 20 sind jeweils über zwei Schrauben 21 an der Klemmplatte 7 festgelegt. Da die Schrauben 21 funktionsnotwendigerweise etwas Spiel aufweisen, kann die Klemmeinrichtung 6 insgesamt durch Verdrehen der Klemmplatte 7 einerseits verstellt beziehungsweise positioniert werden. Andererseits können die einzelnen Klemmfinger 9, 10, 11, 12, 13, 14, 15, 16, 17, 18, 19, 20 im Rahmen des Spiels relativ zur Klemmplatte 7 positioniert werden.

An den Klemmfingern 9, 10, 11, 12, 13, 14, 15, 16, 17, 18, 19, 20 ist jeweils ein Klemmfinger-Referenzmarker 22 vorgesehen. Der Klemmfinger-Referenzmarker 22 ist hierbei exemplarisch durch eine Positioniermarke des Klemmfingers gebildet, welche die Form eines in einem Kreis vorgesehenen Kreuzes besitzt.

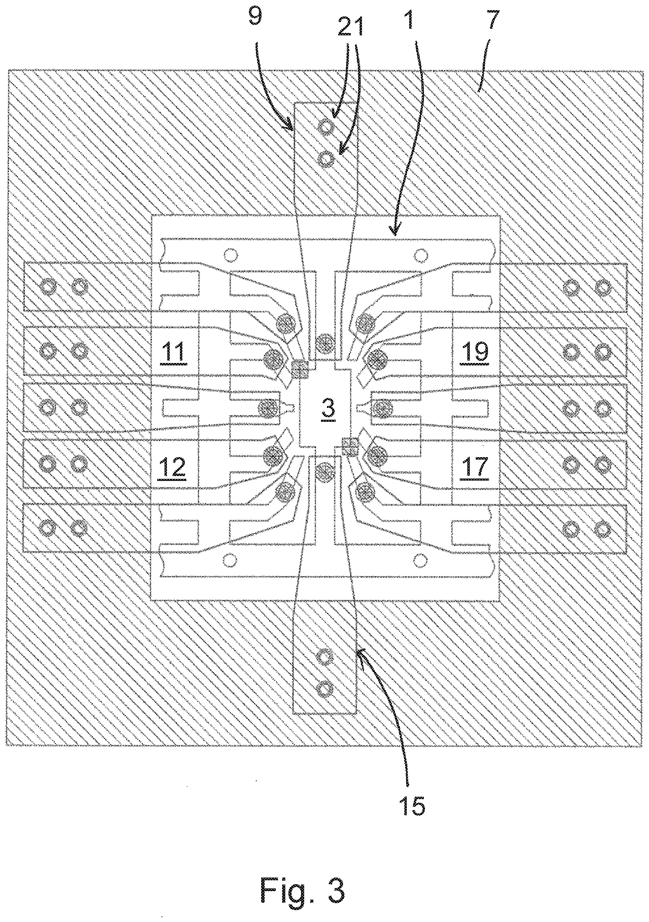

Fig. 3 zeigt die Klemmeinrichtung 6 mit dem in der Aussparung 8 vorgesehen Bondgut 1 nach Fig. 1. Es ist hierbei - ebenso wie in Fig. 2 - zur Kennzeichnung der Zuordnung die Darstellung lediglich prinzipartig dergestalt, dass unsichtbare Linien dargestellt sind zur Verdeutlichung der Lagezuordnung des Bondguts 1 einerseits zur Klemmeinrichtung 6 andererseits beziehungsweise zur Zuordnung der Klemmfinger 9, 10, 11, 12, 13, 14, 15, 16, 17, 18, 19, 20 einerseits zu den Stegen 2 des Bondguts 1 andererseits. Insbesondere ist die Zuordnung so vorgesehen, dass sich im vorliegenden Ausführungsbeispiel der Erfindung die an den Klemmfingern 9, 10, 11, 12, 13, 14, 15, 16, 17, 18, 19, 20 vorgesehenen Klemmfinger-Referenzmarker 22 gerade oberhalb der Bondgut-Referenzmarker 5 befinden, welche an den Stegen 2 des Bondguts 1 vorgesehen sind.

Die Klemmfinger 9, 10, 11, 12, 13, 14, 15, 16, 17, 18, 19, 20 der Klemmeinrichtung 6 sind im vorliegenden Beispiel dem Bondgut 1 so zugeordnet, dass mittels eines geeigneten Handhabungsgeräts der nicht dargestellte Chip auf die Anlagefläche 3 des Bondguts 1 gelegt und dann elektrisch leitende Bondverbindungen zwischen dem Chip einerseits und dem Bondgut 1 andererseits hergestellt werden können. Es ist insofern insbesondere die Lage der Klemmfinger 9, 10, 11, 12, 13, 14, 15, 16, 17, 18, 19, 20 relativ zur Orientierung und Ausgestaltung des Bondguts 1 so gewählt, dass das Bondgut 1 während des Bondprozesses nicht in unzulässiger Weise zu Schwingungen angeregt wird und insbesondere nicht in einer Eigenschwingungsform schwingt und dass ein nicht dargestelltes Bondwerkzeug des Bonders, welches üblicherweise an einem in drei kartesische Koordinaten verfahrbaren und drehbaren Bondkopf gehalten ist, kollisionsfrei verfahren und bewegt werden kann.

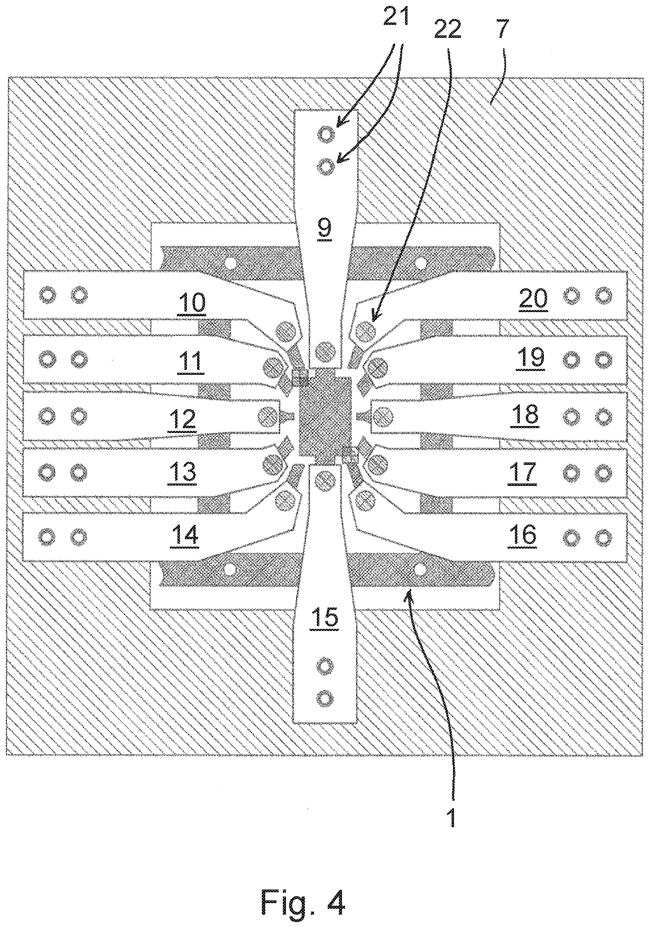

Fig. 4 zeigt eine analoge Darstellung der Bondanordnung nach Fig. 3. Verdeckte Kanten der Klemmplatte 7 und des Bondguts 1 sind hierbei anders als in Fig. 3 nicht dargestellt.

Um die Klemmfinger 9, 10, 11, 12, 13, 14, 15, 16, 17, 18, 19, 20 der Klemmplatte 7 relativ zum Bondgut 1 zu positionieren, wird in einer Initialisierungsroutine zunächst von einem besonders erfahrenen Mitarbeiter eine geeignete Klemmkonfiguration bestimmt. Beispielsweise werden zur Verifikation wenigstens einzelne Anschlusskontakte und bevorzugt alle Anschlusskontakte für das Bondgut 1 hergestellt. Es kann hierdurch geprüft werden, ob das Bondgut 1 in unzulässiger Weise zu Schwingungen angeregt wird beziehungsweise kollisionsfrei gebondet werden kann. Sofern die Klemmkonfiguration den Ansprüchen an den Bondprozess genügt, wird sie als Klemmfinger-Sollposition gespeichert. Die Erfassung erfolgt dabei mittels einer Kamera und nachgelagerten Bildverarbeitungsroutinen.

Im Ausführungsbeispiel der Erfindung nach den Fig. 1 bis 4 können insbesondere die Klemmfinger-Referenzmarken 22 erfasst werden zur Bestimmung der Lage und/oder Orientierung der Klemmfinger 9, 10, 11, 12, 13, 14, 15, 16, 17, 18, 19, 20. Die Erfassung eines einzelnen Punkts je Klemmfinger 9, 10, 11, 12, 13, 14, 15, 16, 17, 18, 19, 20 ist hierbei ausreichend, da aufgrund der Festlegung der Klemmfinger 9, 10, 11, 12, 13, 14, 15, 16, 17, 18, 19, 20 über die Schrauben 21 letztlich allein eine geringfügige rotatorische beziehungsweise lineare Verschiebung der Klemmfinger 9, 10, 11, 12, 13, 14, 15, 16, 17, 18, 19, 20 vorgesehen werden kann mit der Folge, dass die Lage der Klemmfinger 9, 10, 11, 12, 13, 14, 15, 16, 17, 18, 19, 20 durch einen einzigen Klemmfinger-Referenzmarker 22 je Klemmfinger ausreichend genau bestimmt ist.

Selbstverständlich kann bei einer anderen Ausgestaltung der Klemmeinrichtung es notwendig sein, mehr als einen Klemmfinger-Positioniermarker je Klemmfinger optisch zu erfassen, um dann die Position und Orientierung der Klemmfinger mit ausreichender Genauigkeit zu bestimmen. Maßgeblich ist hierbei insbesondere die Art der Festlegung der Klemmfinger an der Klemmplatte der Klemmeinrichtung.

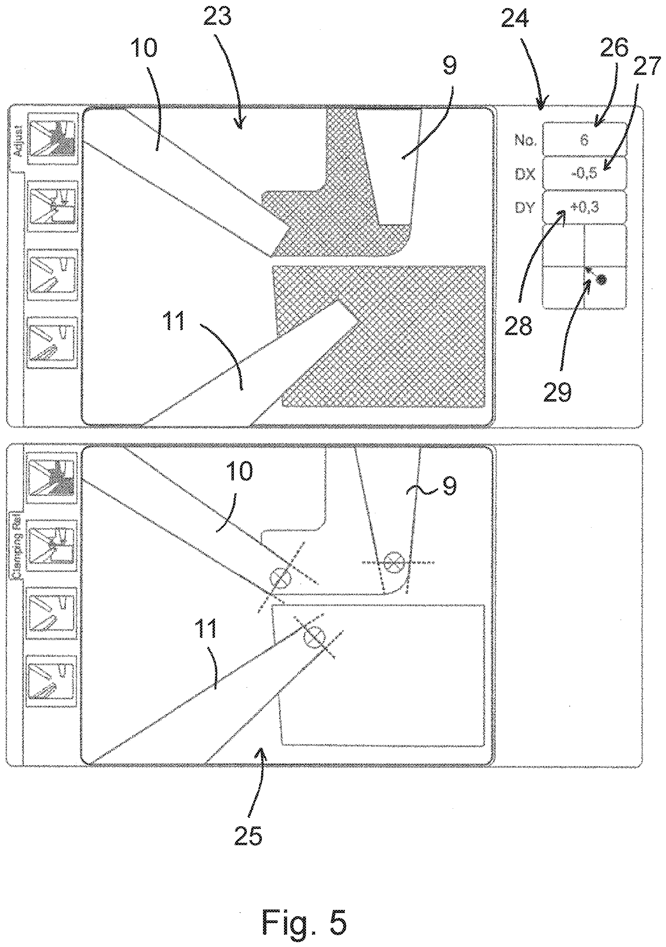

Sofern die Klemmfinger-Sollposition bekannt ist, kann die korrekte Positionierung der Klemmeinrichtung in der nachfolgenden Übernahmeroutine insbesondere grafisch unterstützt werden. Fig. 5 zeigt hierzu ein erstes Beispiel. Es ist in Fig. 5 ein mehrteiliges Anzeigeelement eines Bonders dargestellt. In einem oberen Bildsegment ist zum einen in einem ersten Bildschirmabschnitt 23 ein Referenzbild angezeigt, welches die Klemmfinger-Sollposition für drei Klemmfinger 9, 10, 11 darstellt. Beispielsweise ist das Referenzbild mittels der Kamera aufgenommen worden. In einem zweiten Bildschirmabschnitt 24 des oberen Bildsegments, welcher sich rechts neben dem ersten Bildschirmabschnitt 23 befindet, ist zum einen eine Fehlstellung für einen dritten Klemmfinger 11 dargestellt, der im ersten Bildschirmabschnitt 23 dargestellt ist. Zur Verdeutlichung der Fehlstellung ist zum einen ein Abweichwert 27 in eine X-Richtung und zum anderen Abweichwert 28 in eine Y-Richtung als Zahlenwert angezeigt. Darüber hinaus ist eine Verstellrichtung 29 für den dritten Klemmfinger 11 angezeigt. Der Maschinenführer kann also anhand der Informationen im zweiten Bildschirmabschnitt 24 die Fehlstellung zahlenmäßig und richtungsmäßig sehr schnell erfassen und insofern die Klemmeinrichtung 6 zügig korrekt positionieren. Ferner ist eine Identifikationsnummer 26 für den gerade in der Justage befindlichen Klemmfinger 11 vorgesehen.

In einem dritten Bildschirmabschnitt 25 (unteres Bildsegment) ist überdies die aktuelle Position und Orientierung der drei Klemmfinger 9, 10, 11 dargestellt. Ein Vergleich der Darstellung im ersten Bildschirmabschnitt 23 und im dritten Bildschirmabschnitt 25 erlaubt es dem Maschinenführer insofern, die Fehlstellung schnell zu erfassen und zu korrigieren.

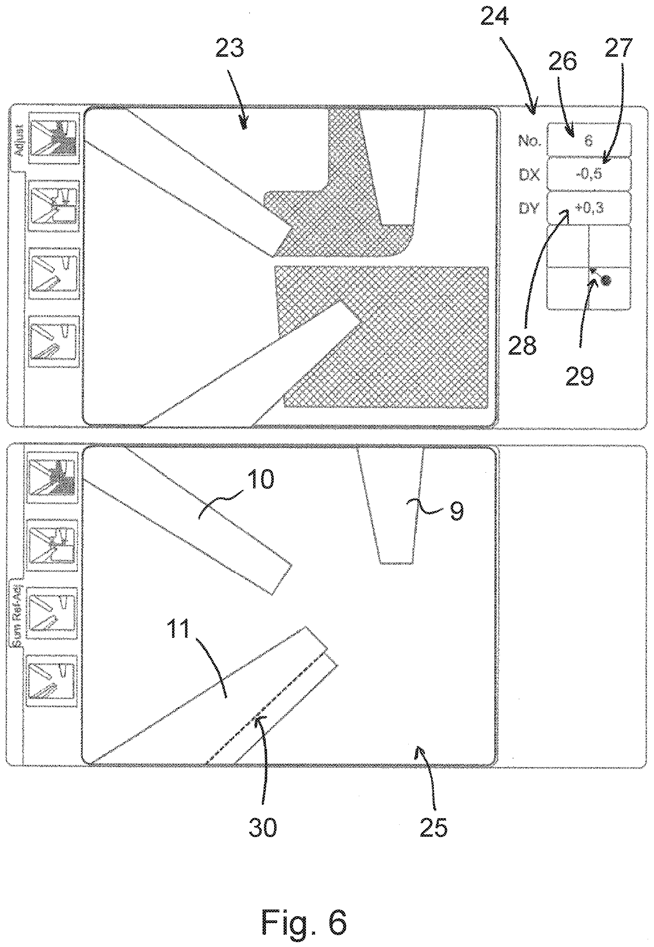

Eine alternative Visualisierung der Fehlstellung ist in Fig. 6 gezeigt. Während in dem ersten Bildschirmabschnitt 23 und in dem zweiten Bildschirmabschnitt 24 die gleichen Informationen beziehungsweise Bildinhalte dargestellt werden, wird im dritten Bildschirmabschnitt 25 ein Summenbild für den dritten Klemmfinger 11 dargestellt. In dem Summenbild sind die Klemmfinger-Sollposition für den dritten Klemmfinger 11 und die aktuelle Position und Orientierung des dritten Klemmfingers 11 addiert mit der Folge, dass der dritte Klemmfinger 11 größer beziehungsweise breiter dargestellt ist, wenn die Klemmfinger-Sollposition nicht korrekt eingestellt ist. Es ist insofern nur ein Überschneidungsbereich eingefärbt beziehungsweise dargestellt.

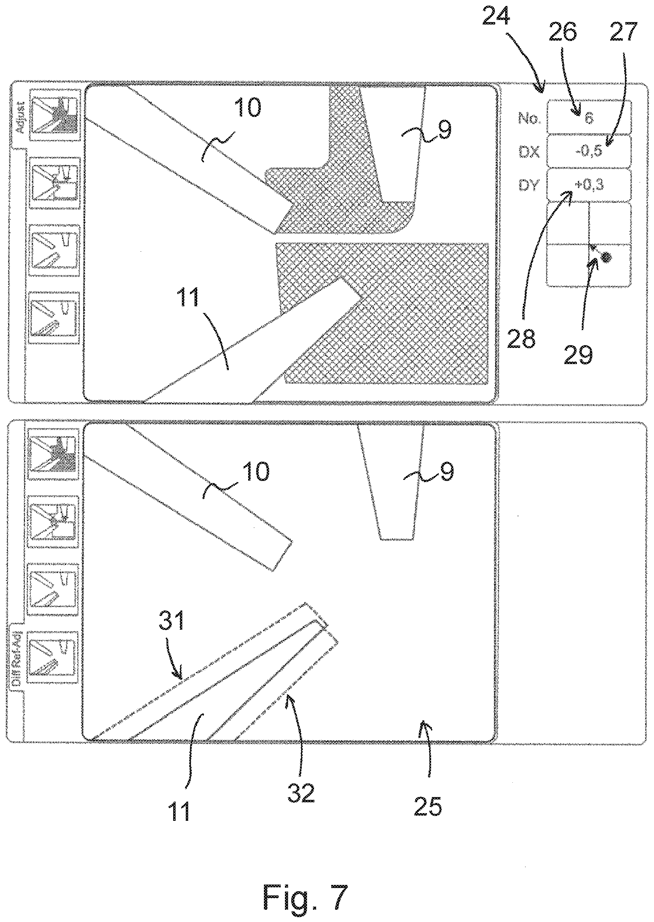

In analoger Weise ist in Fig. 7 für den dritten Klemmfinger 11 eine Differenzbild-Darstellung gewählt. In der Differenzbild-Darstellung sind die Klemmfinger-Sollposition und die aktuelle Position und Orientierung des dritten Klemmfinger 11 subtrahiert mit der Folge, dass der dritte Klemmfinger 11 in der Darstellung nach Fig. 7 schlanker erscheint als er in der Realität ist, solange die Klemmfinger-Sollposition nicht korrekt eingestellt ist.

Jeweils sind in den Fig. 6 und 7 allein zur Orientierung die Klemmfingerkonturen 30, 31, 32 gestrichelt dargestellt, welche die Geometrie des dritten Klemmfingers 11 in der Klemmfinger-Sollposition beziehungsweise der aktuellen Position angeben. Die Klemmfingerkonturlinien 30, 31, 32 sind in der tatsächlichen Darstellung nicht erkennbar. Sie sind hier allein zur Verdeutlichung der Visualisierung dargestellt und zur Erläuterung des dem Summenbild und dem Differenzbild zugrunde liegende Prinzips. Gleiche Bauteile und Bauteilfunktionen sind durch gleiche Bezugszeichen gekennzeichnet.

## Patentansprüche

1. Verfahren zum Festlegen eines Bondguts (1) in einem Arbeitsbereich eines Bonders mittels einer Klemmeinrichtung (6) umfassend eine Initialisierungsroutine mit den folgenden Schritten:
- das Bondgut (1) und die Klemmeinrichtung (6) werden im Arbeitsbereich des Bonders platziert;
**gekennzeichnet durch** folgende Schritte:
- zur Bestimmung der Lage des Bondguts (1) im Arbeitsraum wird mittels der Kamera eine charakteristische (Teil-) Kontur als Bondgut (1) und/oder eine an dem Bondgut (1) vorgesehene Bondgut-Positioniermarke (5) erfasst und als Bondgut-Referenzmarken gespeichert;
- anhand der Bondgut-Referenzmarken (5) wird die Position und/oder Orientierung des Bondguts (1) relativ zum Bonder bestimmt;
- Klemmfinger (9, 10, 11, 12, 13, 14, 15, 16, 17, 18, 19, 20) der Klemmeinrichtung (6) werden so in eine Klemmposition verbracht und an den Klemmfingern (9, 10, 11, 12, 13, 14, 15, 16, 17, 18, 19, 20) der Klemmeinrichtung (6) vorgesehene Klemmflächen derart gegen das Bondgut (1) angelegt, dass in einem nachfolgenden Arbeitsschritt an vorbestimmten Anschlussflächen des Bondguts (1) ein Anschlusskontakt hergestellt werden kann, ohne dass das Bondgut (1) in unzulässiger Weise zu Schwingungen angeregt wird und/oder es beim Verfahren und/oder Positionieren eines Bondwerkzeugs des Bonders zu einer Kollision mit der Klemmeinrichtung (6) kommt;
- die zuvor eingestellte Klemmposition der Klemmfinger (9, 10, 11, 12, 13, 14, 15, 16, 17, 18, 19, 20) wird mittels der Kamera erfasst und es wird die Klemmposition relativ zur Position und/oder Orientierung des Bondguts (1) als Klemmfinger-Sollposition berechnet und gespeichert;
sowie eine Übernahmeroutine mit den folgenden Schritten:
- das Bondgut (1) und die Klemmeinrichtung (6) mit den Klemmfingern (9, 10, 11, 12, 13, 14, 15, 16, 17, 18, 19, 20) werden im Arbeitsbereich des Bonders positioniert;
- eine aktuelle Position und Orientierung des Bondguts (1) und/oder der Klemmeinrichtung (6) werden mittels der Kamera erfasst;
- anhand der aktuellen Position und Orientierung des Bondguts (1) und der Klemmeinrichtung (6) und anhand der gespeicherten Klemmfinger-Sollposition wird eine initiale Fehlstellung der Klemmfinger (9, 10, 11, 12, 13, 14, 15, 16, 17, 18, 19, 20) berechnet und angezeigt;
- iterativ werden die aktuelle Position und Orientierung der Klemmfinger (9, 10, 11, 12, 13, 14, 15, 16, 17, 18, 19, 20) so lange korrigiert und neu erfasst und eine neue Fehlstellung der Klemmfinger (9, 10, 11, 12, 13, 14, 15, 16, 17, 18, 19, 20) berechnet und angezeigt, bis die aktuelle Position und Orientierung der Klemmfinger (9, 10, 11, 12, 13, 14, 15, 16, 17, 18, 19, 20) der Klemmfinger-Sollposition entspricht.

2. Verfahren nach Anspruch 1, **dadurch gekennzeichnet, dass** zueinander relativ bewegliche Klemmfinger (9, 10, 11, 12, 13, 14, 15, 16, 17, 18, 19, 20) der Klemmeinrichtung (6) einzeln positioniert und/oder fixiert werden und/oder dass die Klemmfinger-Sollposition für jeden Klemmfinger (9, 10, 11, 12, 13, 14, 15, 16, 17, 18, 19, 20) einzeln erfasst wird und/oder dass die Position und/oder Orientierung der einzelnen Klemmfinger (9, 10, 11, 12, 13, 14, 15, 16, 17, 18, 19, 20) einzeln korrigiert wird.

3. Verfahren nach Anspruch 1 oder 2, **dadurch gekennzeichnet, dass** zur Bestimmung der aktuellen Position und/oder Orientierung der Klemmfinger (9, 10, 11, 12, 13, 14, 15, 16, 17, 18, 19, 20) und/oder der Klemmfinger-Sollposition mittels der Kamera eine Klemmfinger-Positioniermarke und/oder eine (Teil-) Kontur der Klemmfinger als Klemmfinger-Referenzmarke (22) erfasst werden.

4. Verfahren nach einem der Ansprüche 1 bis 3, **dadurch gekennzeichnet, dass** zum Erfassen der Bondgut-Referenzmarken (5) und/oder zum Erfassen der Klemmfinger-Sollposition der Klemmfinger die Kamera manuell verfahren und/oder über den Bondgut-Referenzmarken (1) und/oder den Klemmfinger-Referenzmarken (22) positioniert wird.

5. Verfahren nach einem der Ansprüche 1 bis 4, **dadurch gekennzeichnet, dass** in der Initialisierungsphase mittels der Kamera ein Referenzbild aufgenommen und gespeichert wird, wenn die Klemmfinger (9, 10, 11, 12, 13, 14, 15, 16, 17, 18, 19, 20) in der Klemmfinger-Sollposition vorgesehen sind.

6. Verfahren nach einem der Ansprüche 1 bis 5, **dadurch gekennzeichnet, dass** in der Übernahmeroutine ein Live-Bild der Kamera oder das Referenzbild und/oder eine Referenzdarstellung einerseits und örtlich getrennt hiervon die Fehlstellung der Klemmfinger andererseits angezeigt werden.

7. Verfahren nach einem der Ansprüche 1 bis 6, **dadurch gekennzeichnet, dass** zur Visualisierung der Fehlstellung die aktuelle Position und/oder Orientierung der Klemmfinger (9, 10, 11, 12, 13, 14, 15, 16, 17, 18, 19, 20) und/oder die Klemmfinger-Sollposition angezeigt werden.

8. Verfahren nach einem der Ansprüche 1 bis 7, **dadurch gekennzeichnet, dass** zur Visualisierung der Fehlstellung die Klemmfinger-Sollposition und die aktuelle Position und/oder Orientierung der Klemmfinger (9, 10, 11, 12, 13, 14, 15, 16, 17, 18, 19, 20) addiert und als Summenbild angezeigt werden.

9. Verfahren nach einem der Ansprüche 1 bis 8, **dadurch gekennzeichnet, dass** zur Visualisierung der Fehlstellung der Klemmfinger-Sollposition und der aktuellen Position und Orientierung der Klemmfinger (9, 10, 11, 12, 13, 14, 15, 16, 17, 18, 19, 20) subtrahiert werden und als Differenzbild angezeigt werden.

10. Verfahren nach einem der Ansprüche 1 bis 9, **dadurch gekennzeichnet, dass** die Fehlstellung relativ zur Klemmfinger-Sollposition berechnet und/oder als Zahlenwert (27, 28) angezeigt werden und/oder dass eine Verstellrichtung (29) für die Klemmfinger (9, 10, 11, 12, 13, 14, 15, 16, 17, 18, 19, 20) angezeigt wird.

11. Verfahren nach einem der Ansprüche 1 bis 10, **dadurch gekennzeichnet, dass** im Rahmen der Initialisierungsroutine vor dem Speichern der Klemmfinger-Sollposition testweise an dem Bondgut (1) wenigstens ein Anschlusskontakt und bevorzugt alle Anschlusskontakte hergestellt werden.

12. Verfahren nach einem der Ansprüche 1 bis 11, **dadurch gekennzeichnet, dass** das Bondgut (1) über eine Fördereinrichtung in den Arbeitsbereich des Bonders zugeführt wird.

13. Verfahren nach einem der Ansprüche 1 bis 12, **dadurch gekennzeichnet, dass** das Bondgut (1) von unten gegen die Kontaktflächen der Klemmeinrichtung (6) angedrückt wird.

14. Verfahren nach einem der Ansprüche 1 bis 13, **dadurch gekennzeichnet, dass** im Rahmen der Übertragungsroutine eine zur Anlage der Kontaktfläche der Klemmeinrichtung (6) vorgesehene Montagestelle mittels eines Lasers auf dem Bondgut markiert wird, insbesondere wenn eine Klemmmarke (4) an dem Bondgut (1) nicht vorgesehen ist.

## Claims

1. Method for fixing a workpiece (1) to be bonded in a working area of a bonder using a clamping device (6), comprising an initialisation routine having the following steps:
- the workpiece (1) to be bonded and the clamping device (6) are placed in the working area of the bonder;
**characterised by** the following steps:
- to determine the position of the workpiece (1) to be bonded in the workspace, a characteristic (partial) contour is detected by the camera as a workpiece (1) to be bonded and/or as a workpiece positioning mark (5) provided on the workpiece (1) to be bonded, and saved as workpiece reference marks;
- by way of the workpiece reference marks (5), the position and/or orientation of the workpiece (1) to be bonded relative to the bonder are determined;
- clamping fingers (9, 10, 11, 12, 13, 14, 15, 16, 17, 18, 19, 20) of the clamping device (6) are brought into a clamping position in such a way, and clamping faces provided on the clamping fingers (9, 10, 11, 12, 13, 14, 15, 16, 17, 18, 19, 20) of the clamping device (6) are laid against the workpiece (1) to be bonded in such a way, that in a following work step a connection contact can be established at predetermined connection faces of the workpiece (1) to be bonded, without the workpiece (1) to be bonded unacceptably being excited to oscillations and/or a collision with the clamping device (6) occurring during the displacement and/or positioning of a workpiece to be bonded of the bonder;
- the previously set-up clamping position of the clamping fingers (9, 10, 11, 12, 13, 14, 15, 16, 17, 18, 19, 20) is detected by the camera, and the clamping position relative to the position and/or orientation of the workpiece (1) to be bonded is calculated as a clamping finger target position and saved;
and by an acceptance routine having the following steps:
- the workpiece (1) to be bonded and the clamping device (6) comprising the clamping fingers (9, 10, 11, 12, 13, 14, 15, 16, 17, 18, 19, 20) are positioned in the working area of the bonder;
- a current position and orientation of the workpiece (1) to be bonded and/or of the clamping device (6) are detected by the camera;
- by way of the current position and orientation of the workpiece (1) to be bonded and of the clamping device (6), and by way of the saved clamping finger target position, an initial incorrect position of the clamping fingers (9, 10, 11, 12, 13, 14, 15, 16, 17, 18, 19, 20) is calculated and displayed;
- iteratively, the current position and orientation of the clamping fingers (9, 10, 11, 12, 13, 14, 15, 16, 17, 18, 19, 20) are corrected and detected again, and a new incorrect position of the clamping fingers (9, 10, 11, 12, 13, 14, 15, 16, 17, 18, 19, 20) is calculated and displayed, until the current position and orientation of the clamping fingers (9, 10, 11, 12, 13, 14, 15, 16, 17, 18, 19, 20) correspond to the clamping finger target position.

2. Method according to claim 1, **characterised in that** clamping fingers (9, 10, 11, 12, 13, 14, 15, 16, 17, 18, 19, 20), which are movable relative to one another, of the clamping device (6) are individually positioned and/or fixed, and/or **in that** the clamping finger target position is detected for each clamping finger (9, 10, 11, 12, 13, 14, 15, 16, 17, 18, 19, 20) individually, and/or **in that** the position and/or orientation of the individual clamping fingers (9, 10, 11, 12, 13, 14, 15, 16, 17, 18, 19, 20) are corrected individually.

3. Method according to either claim 1 or claim 2, **characterised in that**, to determine the current position and/or orientation of the clamping fingers (9, 10, 11, 12, 13, 14, 15, 16, 17, 18, 19, 20) and/or the clamping finger target position, a clamping finger positioning mark and/or a (partial) contour of the clamping fingers are detected by the camera as a clamping finger reference mark (22).

4. Method according to any of claims 1 to 3, **characterised in that**, to detect the workpiece reference marks (5) and/or to detect the clamping finger target position, the camera is manually displaced and/or is positioned by way of the workpiece reference marks (1) and/or clamping finger reference marks (22).

5. Method according to any of claims 1 to 4, **characterised in that** in the initialisation phase a reference image is captured by the camera and saved when the clamping fingers (9, 10, 11, 12, 13, 14, 15, 16, 17, 18, 19, 20) are provided in the clamping finger target position.

6. Method according to any of claims 1 to 5, **characterised in that** in the acceptance routine a live image from the camera or the reference image and/or a reference drawing, on the one hand, and spatially separated therefrom the incorrect position, on the other hand, are displayed.

7. Method according to any of claims 1 to 6, **characterised in that**, to visualise the incorrect position, the current position and/or orientation of the clamping fingers (9, 10, 11, 12, 13, 14, 15, 16, 17, 18, 19, 20) and/or the clamping finger target position are displayed.

8. Method according to any of claims 1 to 7, **characterised in that**, to visualise the incorrect position, the clamping finger target position and the current position and/or orientation of the clamping fingers (9, 10, 11, 12, 13, 14, 15, 16, 17, 18, 19, 20) are added and displayed as a sum image.

9. Method according to any of claims 1 to 8, **characterised in that**, to visualise the incorrect position, the clamping finger target position and the current position and orientation of the clamping fingers (9, 10, 11, 12, 13, 14, 15, 16, 17, 18, 19, 20) are subtracted and displayed as a difference image.

10. Method according to any of claims 1 to 9, **characterised in that** the incorrect position relative to the clamping finger target position is calculated and/or displayed as a numerical value (27, 28), and/or **in that** an adjustment direction (29) for the clamping fingers (9, 10, 11, 12, 13, 14, 15, 16, 17, 18, 19, 20) is displayed.

11. Method according to any of claims 1 to 10, **characterised in that**, in the initialisation routine, before the clamping finger target position is saved, at least one connection contact and preferably all connection contacts with the workpiece (1) to be bonded are established for testing purposes.

12. Method according to any of claims 1 to 11, **characterised in that** the workpiece (1) to be bonded is supplied to the working area of the bonder via a conveying device.

13. Method according to any of claims 1 to 12, **characterised in that** the workpiece (1) to be bonded is pressed against the contact faces of the clamping device (6) from below.

14. Method according to any of claims 1 to 13, **characterised in that**, in the acceptance routine, a mounting position provided for the contact of the contact face of the clamping device (6) is marked by a laser on the workpiece to be bonded, in particular if a clamping mark (4) is not provided on the workpiece (1) to be bonded.

## Revendications

1. Procédé de fixation d'une pièce à souder (1) dans une zone de travail d'un dispositif de soudage au moyen d'un dispositif de serrage (6), comprenant une routine d'initialisation comprenant les étapes suivantes:
- la pièce à souder (1) et le dispositif de serrage (6) sont placés dans la zone de travail du dispositif de soudage;
**caractérisé par** les étapes suivantes:
- pour déterminer la position de la pièce à souder (1) dans la zone de travail, un contour caractéristique (partiel) de la pièce à souder (1) et/ou une marque de positionnement de pièce à souder (5) prévue sur la pièce à souder (1) sont acquis au moyen de la caméra et mémorisés en tant que marques de référence de pièce à souder;
- la position et/ou l'orientation de la pièce à souder (1) par rapport au dispositif de soudage sont déterminées sur la base des marques de référence de pièce à souder (5);
- des doigts de serrage (9, 10, 11, 12, 13, 14, 15, 16, 17, 18, 19, 20) du dispositif de serrage (6) sont amenés dans une position de serrage et des surfaces de serrage prévues sur les doigts de serrage (9, 10, 11, 12, 13, 14, 15, 16, 17, 18, 19, 20) du dispositif de serrage (6) sont appliquées contre la pièce à souder (1) de telle sorte que, dans une étape de travail ultérieure, un contact de raccordement peut être établi au niveau de surfaces de raccordement prédéterminées de la pièce à souder (1) sans que la pièce à souder (1) soit excitée en vibrations de manière inadmissible et/ou qu'une collision avec le dispositif de serrage (6) se produise lors du déplacement et/ou du positionnement d'un outil de liaison du dispositif de soudage;
- la position de serrage des doigts de serrage (9, 10, 11, 12, 13, 14, 15, 16, 17, 18, 19, 20) précédemment réglée est acquise au moyen de la caméra et la position de serrage par rapport à la position et/ou à l'orientation de la pièce à souder (1) est calculée et mémorisée en tant que position de consigne des doigts de serrage;
et une routine de prise en charge comprenant les étapes suivantes:
- la pièce à souder (1) et le dispositif de serrage (6) muni des doigts de serrage (9, 10, 11, 12, 13, 14, 15, 16, 17, 18, 19, 20) sont positionnés dans la zone de travail du dispositif de soudage;
- une position et une orientation actuelles de la pièce à souder (1) et/ou du dispositif de serrage (6) sont acquises au moyen de la caméra;
- un mauvais positionnement initial des doigts de serrage (9, 10, 11, 12, 13, 14, 15, 16, 17, 18, 19, 20) est calculé et affiché sur la base de la position et de l'orientation actuelles de la pièce à souder (1) et du dispositif de serrage (6) et sur la base de la position de consigne mémorisée des doigts de serrage;
- de manière itérative, la position et l'orientation actuelles des doigts de serrage (9, 10, 11, 12, 13, 14, 15, 16, 17, 18, 19, 20) sont corrigées et acquises à nouveau, et un nouveau mauvais positionnement des doigts de serrage (9, 10, 11, 12, 13, 14, 15, 16, 17, 18, 19, 20) est calculé et affiché jusqu'à ce que la position et l'orientation actuelles des doigts de serrage (9, 10, 11, 12, 13, 14, 15, 16, 17, 18, 19, 20) correspondent à la position de consigne des doigts de serrage.

2. Procédé selon la revendication 1, **caractérisé en ce que** les doigts de serrage (9, 10, 11, 12, 13, 14, 15, 16, 17, 18, 19, 20) mobiles les uns par rapport aux autres du dispositif de serrage (6) sont positionnés et/ou fixés individuellement et/ou que la position de consigne des doigts de serrage pour chaque doigt de serrage (9, 10, 11, 12, 13, 14, 15, 16, 17, 18, 19, 20) est acquise individuellement et/ou que la position et/ou l'orientation des doigts de serrage individuels (9, 10, 11, 12, 13, 14, 15, 16, 17, 18, 19, 20) sont corrigées individuellement.

3. Procédé selon la revendication 1 ou 2, **caractérisé en ce que**, pour déterminer la position et/ou l'orientation actuelles des doigts de serrage (9, 10, 11, 12, 13, 14, 15, 16, 17, 18, 19, 20) et/ou la position de consigne des doigts de serrage, une marque de positionnement de doigt de serrage et/ou un contour (partiel) des doigts de serrage sont acquis en tant que marque de référence de doigt de serrage (22) au moyen de la caméra.

4. Procédé selon l'une des revendications 1 à 3, **caractérisé en ce que**, pour acquérir les marques de référence de pièce à souder (5) et/ou pour acquérir la position de consigne des doigts de serrage, la caméra est déplacée et/ou positionnée manuellement au-dessus des marques de référence de pièce à souder (1) et/ou des marques de référence de doigt de serrage (22).

5. Procédé selon l'une des revendications 1 à 4, **caractérisé en ce que**, dans la phase d'initialisation, une image de référence est prise et mémorisée au moyen de la caméra lorsque les doigts de serrage (9, 10, 11, 12, 13, 14, 15, 16, 17, 18, 19, 20) sont prévus dans la position de consigne des doigts de serrage.

6. Procédé selon l'une des revendications 1 à 5, **caractérisé en ce que**, dans la routine de prise en charge, une image en direct de la caméra ou l'image de référence et/ou une représentation de référence, d'une part et, de manière localement séparée de celle-ci, le mauvais positionnement des doigts de serrage, d'autre part, sont affichés.

7. Procédé selon l'une des revendications 1 à 6, **caractérisé en ce que**, pour la visualiser le mauvais positionnement, la position et/ou l'orientation actuelles des doigts de serrage (9, 10, 11, 12, 13, 14, 15, 16, 17, 18, 19, 20) et/ou la position de consigne des doigts de serrage sont affichées.

8. Procédé selon l'une des revendications 1 à 7, **caractérisé en ce que**, pour visualiser le mauvais positionnement, la position de consigne des doigts de serrage et la position et/ou l'orientation actuelles des doigts de serrage (9, 10, 11, 12, 13, 14, 15, 16, 17, 18, 19, 20) sont additionnés et affichées sous la forme d'une image de somme.

9. Procédé selon l'une des revendications 1 à 8, **caractérisé en ce que**, pour visualiser le mauvais positionnement, la position de consigne des doigts de serrage et la position et l'orientation actuelles des doigts de serrage (9, 10, 11, 12, 13, 14, 15, 16, 17, 18, 19, 20) sont soustraites et affichées sous la forme d'une image de différence.

10. Procédé selon l'une des revendications 1 à 9, **caractérisé en ce que** le mauvais positionnement par rapport à la position de consigne des doigts de serrage est calculé et/ou affiché sous la forme d'une valeur numérique (27, 28) et/ou qu'une direction de réglage (29) pour les doigts de serrage (9, 10, 11, 12, 13, 14, 15, 16, 17, 18, 19, 20) est affichée.

11. Procédé selon l'une des revendications 1 à 10, **caractérisé en ce que**, dans le cadre de la routine d'initialisation, au moins un contact de raccordement et de préférence tous les contacts de raccordement sont établis sur la pièce à souder (1) à titre d'essai avant que la position de consigne des doigts de serrage soit mémorisée.

12. Procédé selon l'une des revendications 1 à 11, **caractérisé en ce que** la pièce à souder (1) est amenée dans la zone de travail du dispositif de soudage au moyen d'un dispositif de transport.

13. Procédé selon l'une des revendications 1 à 12, **caractérisé en ce que** la pièce à souder (1) est pressée par le bas contre les surfaces de contact du dispositif de serrage (6).

14. Procédé selon l'une des revendications 1 à 13, **caractérisé en ce que**, dans le cadre de la routine de prise en charge, un point de montage prévu pour l'application de la surface de contact du dispositif de serrage (6) est marqué sur la pièce à souder au moyen d'un laser, en particulier si une marque de serrage (4) n'est pas prévue sur la pièce à souder (1).
